Europäisches Patentamt

European Patent Office

Office européen des brevets

(19)

(11) Publication number: **0 642 174 A1**

(12) **EUROPEAN PATENT APPLICATION**

(21) Application number: **94112155.0**

(22) Date of filing: **03.08.94**

(51) Int. Cl.6: **H01L 29/812**, H01L 29/08, H01L 29/10

(30) Priority: **03.08.93 JP 192328/93**

(43) Date of publication of application:
**08.03.95 Bulletin 95/10**

(84) Designated Contracting States:
**DE FR GB SE**

(71) Applicant: **SUMITOMO ELECTRIC INDUSTRIES, LTD.**
**5-33, Kitahama 4-chome,**
**Chuo-ku**
**Osaka-shi,**
**Osaka 541 (JP)**

(72) Inventor: **Shiga, Nobuo, c/o Yokohama Works of Sumitomo**
**Electric Ind., Ltd.,**
**1, Taya-cho,**
**Sakae-ku**
**Yokohama-shi,**
**Kanagawa 244 (JP)**

(74) Representative: **Lehn, Werner, Dipl.-Ing. et al**
**Hoffmann, Eitle & Partner,**
**Patentanwälte,**
**Arabellastrasse 4**
**D-81925 München (DE)**

(54) **MESFET with low ohmic resistance.**

(57) A field effect transistor of the present invention includes a semiconductor substrate (1), an active layer (2) formed by doping an impurity in a surface region of the semiconductor substrate, two heavily doped layers (3,4) formed respectively by doping the impurity at the two end portions of the active layer, a gate electrode (5) formed on the active layer to be in Schottky contact with the active layer, and source and drain electrodes (6,7) formed respectively on the two heavily doped layers to be in ohmic contact with the two heavily doped layers. The length $W_C$ of a portion where a gate-electrode-side portion of at least one of said source and drain electrodes and said heavily doped layer overlap each other is set with respect to a length $W_G$ of a portion where at least one of source- and drain-electrode-side edge portions of said gate electrode and said active layer overlap each other to satisfy 1-[$\mu$m] + $W_G$ < $W_C$ < $5W_G$. For this reason, a drain current flowing in the gate-electrode-side edge portion of the source or drain electrode is distributed as compared to the prior art, thereby reducing the contact resistance of the source or drain electrode. Therefore, since the drain-source resistance in an ON state is reduced, the field effect transistor can be applied to a circuit which requires a high breakdown voltage as needed.

F i g . I

## BACKGROUND OF THE INVENTION

### Field of the Invention

The present invention relates to a field effect transistor (FET) manufactured using a semiconductor substrate consisting of GaAs, InP, or the like and, more particularly, to a field effect transistor effectively applied to a high output amplifier or switching circuit which operates at a microwave frequency band.

### Related Background Art

With the recent advance of a mobile communication system, a demand for compact and high-performance components which operate at a high frequency has increased. In correspondence with this tendency, FETs, and particularly MESFETs manufactured using a compound semiconductor such as GaAs, or HEMTs are put to practical use as transistors usable beyond the characteristic limit of an Si bipolar transistor conventionally used in a high frequency band.

As a conventional FET, a GaAs Schottky gate field effect transistor (GaAs-MESFET) generally has a structure in which an n-type active layer is formed in a semiconductor substrate, and $n^+$-type heavily doped layers are formed at the two end portions of the active layer. In addition, a gate electrode is formed on the active layer to be in Schottky contact with the active layer. A source electrode and a drain electrode are formed on the two heavily doped layers to be in ohmic contact with the heavily doped layers, respectively.

In the manufacturing process of such an FET, when a pattern is to be formed on the semiconductor substrate by, e.g., an optical exposure technique, in order to ensure an alignment margin with respect to a pattern formed in advance, a next pattern is sometimes formed only slightly larger with a small margin in correspondence with the maximum misalignment of the exposure apparatus. For this reason, in consideration of the necessary minimum size of the alignment margin for pattern formation, each of the two heavily doped layers is formed partially larger than the active layer. Similarly, the gate electrode is formed partially larger than the active layer. The source and drain electrodes are formed partially larger than the heavily doped layers, respectively. However, the difference is as large as about 0.1 to 1 $\mu$m. Such a small size can be ignored as compared to a normal gate width.

An ohmic electrode refers to a source or drain electrode formed to be in ohmic contact with a heavily doped layer. A gate width $W_G$ refers to the length of a portion where the source- or drain-electrode-side edge portion of the gate electrode and the active layer overlap each other. A contact width $W_C$ refers to the length of a portion where the gate-electrode-side edge portion of the ohmic electrode and the heavily doped layer overlap each other.

Therefore, in the conventional FET, the gate width W and the contact width $W_C$ are formed to be almost matched with each other with a difference falling within a range of the minimum necessary alignment margin for pattern formation of the active and heavily doped layers.

In various equipments constituting a mobile communication terminal or system, FETs applied to a power amplification circuit or an antenna transmit-receive high-frequency switching circuit are required. Since the power amplification circuit consumes most power in a terminal or equipment, reduction of power consumption, i.e., efficient power consumption is required. The high-frequency switching circuit is required to have a small insertion loss. Therefore, FETs applied to these components must have a low drain-source resistance in an ON state.

An ON resistance $R_{ON}$ refers to a drain-source resistance constituted by a series resistance $R_D$ and a contact resistance $R_C$ in the ON state of the FET. A series resistance $R_D$ is a resistance measured between the gate electrode and the ohmic electrode. A contact resistance $R_C$ is a resistance measured at a contact portion between the ohmic electrode and the heavily doped layer which is in contact with the ohmic electrode.

In the above conventional FET, when the interval between the gate electrode and the ohmic electrode is deceased to reduce the series resistance $R_D$, a drain breakdown voltage decreases. However, in the FET of a power amplification circuit, to increase the output power, the drain breakdown voltage must be increased by relaxing a field concentration at the gate-electrode-side edge portion of the drain electrode. In the FET of a high-frequency switching circuit, since a high-power signal passes through the FET when it is connected to the transmission circuit side, the drain breakdown voltage must be similarly increased. For this reason, in order to increase the breakdown voltage of the FET, the drain electrode cannot be arranged closer to the gate electrode.

In the above conventional FET, since a drain current mostly flows in the gate-electrode-side edge portion of the ohmic electrode, the contact resistance $R_C$ is determined by the contact width $W_C$. However, the contact width $W_C$ is almost equal to the gate width $W_G$. The gate width $W_G$ is determined in advance by requirements on the circuit design. For this reason, to reduce the contact resistance $R_C$, the contact width $W_C$ cannot be increased beyond the required range.

A consideration of such a field concentration at the gate-electrode-side edge portion of the ohmic electrode is described in detail in "Williams. Ralph, Modern GaAs processing Methods, chap. 11, Boston. London, Artech House Inc.".

## SUMMARY OF THE INVENTION

The present invention has been made in consideration of the above problems, and has as its object to provide a field effect transistor applicable to a circuit which requires a high breakdown voltage as needed, wherein a contact resistance in an ohmic electrode is reduced without increasing a gate width determined by requirements on a circuit design beyond the required range, thereby reducing a drain-source resistance in an ON state.

In order to achieve the above object, according to the present invention, there is provided a field effect transistor comprising a semiconductor substrate, an active layer formed by doping an impurity in a surface region of the semiconductor substrate, two heavily doped layers formed respectively by doping the impurity at two end portions of the active layer, a gate electrode formed on the active layer to be in Schottky contact with the active layer, and source and drain electrodes formed respectively on the two heavily doped layers to be in ohmic contact with the two heavily doped layers, wherein a length $W_C$ of a portion where a gate-electrode-side portion of at least one of the source and drain electrodes and the heavily doped layer overlap each other is larger than a length $W_G$ of a portion where at least one of source-and drain-electrode-side edge portions of the gate electrode and the active layer overlap each other beyond the necessary minimum size of the alignment margin for pattern formation of the active layer and the heavily doped layers.

The length $W_C$ of a portion where a gate-electrode-side portion of at least one of the source and drain electrodes and the heavily doped layer overlap each other may be within the range where the concentration of a current flowing in a gate-electrode-side edge portion of at least one of the source and the drain electrodes is sufficiently relaxed.

A length $W_A$ of a portion where a gate-electrode-side portion of at least one of the source and drain electrodes and the activity layer overlap each other may be larger than the length $W_G$ of a portion where at least one of source- and drain-electrode-side edge portions of the gate electrode and the active layer overlap each other beyond the necessary minimum size of the alignment margin for pattern formation of the active layer and the heavily doped layers.

In order to achieve the above object, according to the present invention, there is provided a field effect transistor comprising a semiconductor substrate, an active layer formed by doping an impurity in a surface region of the semiconductor substrate, two heavily doped layers formed respectively by doping the impurity at two end portions of the active layer, a gate electrode formed on the active layer to be in Schottky contact with the active layer, a source electrode formed on one of the two heavily doped layers to be in ohmic contact with the one heavily doped layer, and a drain electrode formed on the other of the two heavily doped layers to be in ohmic contact with the other heavily doped layer, wherein a length $W_C$ of a portion where a gate-electrode-side portion of at least one of the source and drain electrodes and the heavily doped layer overlap each other is set with respect to a length $W_G$ of a portion where at least one of source- and drain-electrode-side edge portions of the gate electrode and the active layer overlap each other to satisfy

$$1[\mu m] + W_G < W_C < 5W_G.$$

A length $W_C$ of a portion where a gate-electrode-side portion of at least one of the source and drain electrodes and the heavily doped layer overlap each other may be set with respect to the length $W_G$ to satisfy

$$1[\mu m] + W_G < W_A < 5W_G.$$

The active layer may be divided into a plurality of active layers and arranged along a direction of a portion where at least one of source- and drain-electrode-side edge portions of the gate electrode and the active layer overlap each other at a predetermined interval.

The gate electrode may be arranged closer to the heavily doped layer overlapping the source electrode than the heavily doped layer overlapping the drain electrode.

The active layer may be formed by selectively doping the impurity in the semiconductor substrate, and the heavily doped layers may be formed respectively by selectively doping the impurity at the two end portions of the active layer.

The heavily doped layers may be formed respectively by selectively doping the impurity in the semiconductor substrate, the active layer may be doped with the impurity, crystal-grown on the heavily doped layers, and formed into a mesa shape, and devices are isolated from each other.

The active layer and the heavily doped layers may be doped with the impurity, sequentially crystal-grown on the semiconductor substrate, and formed into a mesa shape, and devices are isolated from each other.

In the field effect transistor of the present invention, the length $W_C$ of a portion where the gate-electrode-side edge portion of the source or drain electrode and the heavily doped layer overlap each other is larger than a length $W_G$ of a portion where the source-or drain-electrode-side edge portion of the gate electrode and the active layer overlap each other, which is determined by requirements on the circuit design, at a predetermined ratio beyond the minimum necessary size of the alignment margin for pattern formation of the active and heavily doped layers. With this structure, a drain current flowing in the gate-electrode-side edge portion of the source or drain electrode is distributed as compared to the prior art. That is, the concentration of a current flowing in the gate-electrode-side edge portion of the source or drain electrode is sufficiently relaxed. For this reason, the contact resistance of the source or drain electrode can be reduced.

As a result, with a structure in which a distance between the gate electrode and the source or drain electrode is held at a predetermined value to ensure a high breakdown voltage, the source-drain resistance in an ON state can be reduced to a desired value. Therefore, by applying the field effect transistor of the present invention, power consumption of a power amplification circuit can be reduced, i.e., the power efficiency can be improved, and an insertion loss of a high-frequency switching circuit can be reduced.

It is preferable that a length $W_A$ of a portion where a gate-electrode-side portion of at least one of the source and drain electrodes and the activity layer overlap each other is larger than the length $W_G$ of a portion where at least one of source- and drain-electrode-side edge portions of the gate electrode and the active layer overlap each other at a predetermined ratio beyond the necessary minimum size of the alignment margin for pattern formation of the active layer and the heavily doped layers. With this structure, the drain current flowing in the gate-electrode-side edge portion of the source or drain electrode is further distributed, thereby further reducing the contact resistance of the source or drain electrode.

It is preferable that the active layer is divided into a plurality of active layers and arranged along the direction of the gate width at a predetermined interval. With this structure, the drain current flowing in the gate-electrode-side edge portion of the source or drain electrode more uniformly flows against the direction of the gate width, thereby further reducing the contact resistance of the source or drain electrode.

It is preferable that the gate electrode is arranged closer to the heavily doped layer overlapping the source electrode than the heavily doped layer overlapping the drain electrode. With this structure, the series resistance between the gate electrode and the drain electrode increases, thereby increasing the drain breakdown voltage.

The present invention will become more fully understood from the detailed description given hereinbelow and the accompanying drawings which are given by way of illustration only, and thus are not to be considered as limiting the present invention.

Further scope of applicability of the present invention will become apparent from the detailed description given hereinafter. However, it should be understood that the detailed description and specific examples, while indicating preferred embodiments of the invention, are given by way of illustration only, since various changes and modifications within the spirit and scope of the invention will become apparent to those skilled in the art from this detailed description.

BRIEF DESCRIPTION OF THE DRAWINGS

Fig. 1 is a plan view showing the structure of a field effect transistor according to the first embodiment of the present invention;
Fig. 2 is a sectional view showing the structure taken along a line B - B in Fig. 1;
Fig. 3 is a plan view showing the structure of a field effect transistor according to the second embodiment of the present invention;
Fig. 4 is a sectional view showing the structure taken along a line B - B in Fig. 3;
Fig. 5 is a plan view showing the structure of a field effect transistor according to the third embodiment of the present invention;
Fig. 6 is a sectional view showing the structure taken along a line B - B in Fig. 5;
Fig. 7 is a plan view showing the structure of a field effect transistor according to the fourth embodiment of the present invention;
Fig. 8 is a sectional view showing the structure taken along a line B - B in Fig. 7;
Fig. 9 is a plan view showing the structure of a field effect transistor according to the fifth embodiment of the present invention; and
Fig. 10 is a sectional view showing the structure taken along a line B - B in Fig. 9;
Fig. 11 is a graph showing the relationship between a ratio of the contact width to the gate width and the contact resistance in the field effect transistors according to the above embodiments of the present invention.

## DETAILED DESCRIPTION OF THE PREFERRED EMBODIMENTS

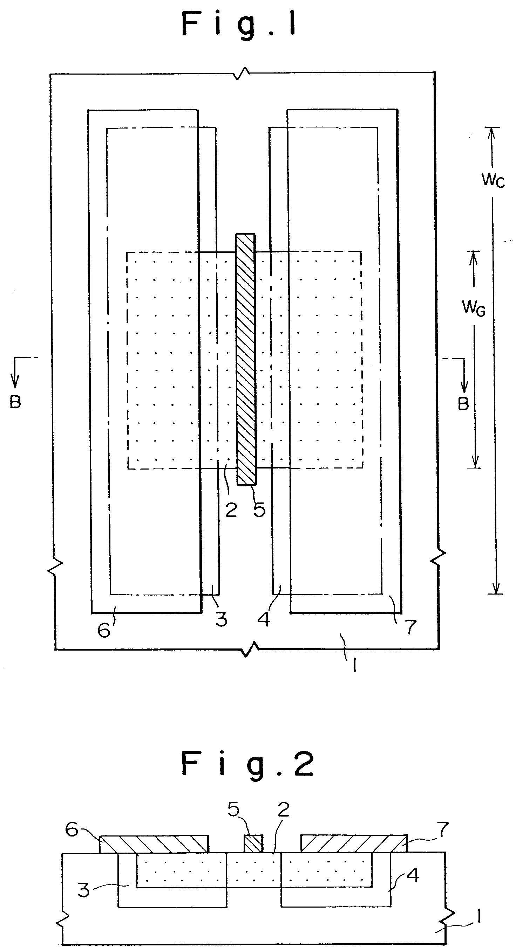

The structures and the functions of the embodiments according to the present invention will be described below with reference to Figs. 1 to 11. The same reference numerals and symbols throughout the drawings denote the same elements, and a detailed description thereof will be omitted. The sizes in the drawings do not necessarily accord with those in the description.

Fig. 1 is a plan view showing the structure of a field effect transistor according to the first embodiment of the present invention. Fig. 2 is a sectional view showing the structure taken along a line B - B in Fig. 1. In this embodiment, the present invention is applied a GaAs-MESFET.

A donor impurity such as Si ions is selectively ion-implanted in a predetermined surface region of a semiconductor substrate 1 consisting of GaAs to form an n-type active layer 2. The donor impurity such as Si ions is further selectively ion-implanted at the two end portions of the active layer 2 to form n-type heavily doped layers 3 and 4.

A gate electrode 5 consisting of Ti/Pt/Au is formed on the active layer 2 to be in Schottky contact with the active layer 2. A source electrode 5 and a drain electrode 7 consisting of AuGe/Ni are formed on the heavily doped layers 3 and 4 to be in ohmic contact with the heavily doped layers 3 and 4, respectively.

Here, the active layer 2 has a dopant concentration of about $2 \times 10^{18}$ cm$^{-3}$ and a thickness of about 0.01 $\mu$m. The heavily doped layers 3 and 4 have a dopant concentration of about $2 \times 10^{17}$ cm$^{-3}$ and a thickness of about 0.07 $\mu$m, respectively. The gate electrode 5 has a gate length of about 0.7 $\mu$m, a gate width of about 200 $\mu$m and a thickness of about 1 $\mu$m. The source electrode 6 and the drain electrode 7 have a thickness of about 0.1 $\mu$m, respectively. An interval between the gate electrode 5 and the source electrode 6 is about 0.5 $\mu$m. An interval between the gate electrode 5 and the drain electrode 7 is about 2 $\mu$m.

In this FET, the active layer 2 is formed in correspondence with the gate width $W_G$ determined by requirements on the circuit design. In consideration of the alignment margin of pattern formation with respect to the active layer 2, the gate electrode 5 is formed partially larger than the active layer 2 along a direction of the gate width $W_G$. Exceeding the alignment margin with respect to the active layer 2, the heavily doped layers 3 and 4 are formed to largely extend beyond the active layer 2 along the direction of the gate width $W_G$. In consideration of the alignment margin with respect to the heavily doped layers 3 and 4, the source and drain electrodes 6 and 7 are formed partially larger than the heavily doped layers 3 and 4 along the direction of the gate width $W_G$, respectively.

As described above, the contact width $W_C$ on the source and drain electrodes is set with respect to the gate width $W_G$ to satisfy

$$1[\mu m] + W_G < W_C < 5W_G.$$

Therefore, in this FET, the contact width $W_C$ on the source and drain electrodes is designed to be larger than the gate width $W_G$ at a predetermined ratio. This ratio is determined in correspondence with the desired value of an ON resistance $R_{ON}$ in consideration of the value of a contact resistance $R_C$ per unit length of the ohmic electrode along the direction of the gate width $W_G$ in accordance with an device structure and a manufacturing technique to which the present invention is applied. However, a structure in which the contact width $W_C$ is larger than the gate width $W_G$ by only the size of the alignment margin necessary for normal pattern formation is not included in this embodiment.

The function of the first embodiment will be described below.

In this FET, the heavily doped layers 3 and 4 are patterned to be largely extend along the direction of the gate width $W_G$ such that the contact width $W_C$ becomes larger than the gate width $W_G$ determined by requirements on the circuit design at a predetermined ratio. With this structure, since a drain current flowing in the gate-electrode-side edge portions of the source electrode 6 and the drain electrode 7 is distributed as compared to a conventional FET, the contact resistance $R_C$ of the ohmic electrode is reduced.

For this reason, with a structure in which a distance between the gate electrode 5 and the ohmic electrode is held at a predetermined value to ensure a high breakdown voltage, the ON resistance $R_{ON}$ is reduced to a desired value. Therefore, power consumption of a power amplification circuit can be reduced, i.e., the power efficiency can be improved, and an insertion loss of a high-frequency switching circuit can be reduced.

In addition, this FET is realized by changing the etching mask pattern to change the layout design of the heavily doped layers 3 and 4 and the corresponding ohmic electrodes in the same structure perpendicular to the semiconductor substrate surface as that of the conventional FET. For this reason, according to the present invention, there is provided an FET applied as a high-performance FET which operates at the high-frequency band of a microwave while holding the conventional manufacturing process.

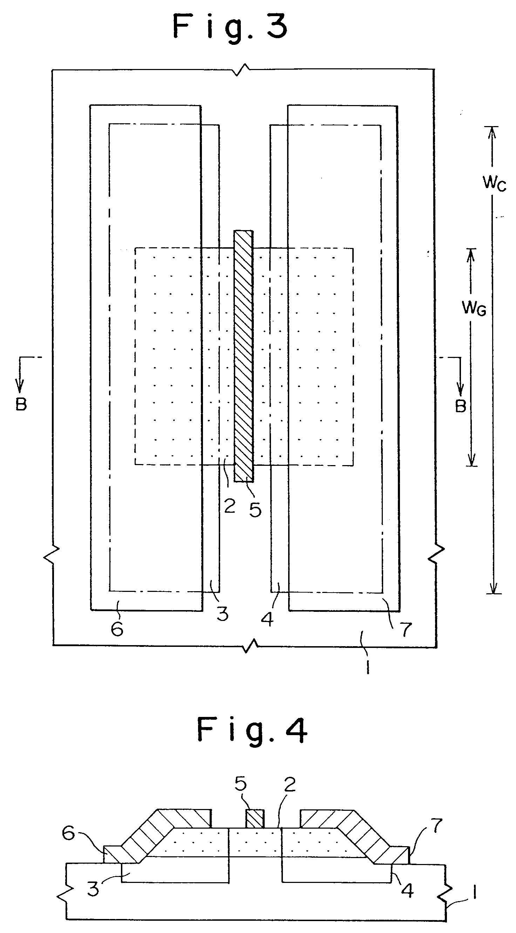

Fig. 3 is a plan view showing the structure of a field effect transistor according to the second embodiment of the present invention. Fig. 4 is a sectional view showing the structure taken along a line B - B in Fig. 3. Also in this embodiment, the present invention is applied to a GaAs-MESFET.

A donor impurity such as Si ions is selectively ion-implanted in two predetermined surface regions of a semiconductor substrate 1 consisting of GaAs to form n-type heavily doped layers 3 and 4. An n-type active layer 2 doped with the donor impurity such as Si ions is crystal-grown on the semiconductor substrate 1. The active layer 2 is etched into a mesa shape while covering the heavily doped layers 3 and 4, and these devices are isolated from each other.

A gate electrode 5 consisting of Ti/Pt/Au is formed on the active layer 2 to be in Schottky contact with the active layer 2. A source electrode 6 and a drain electrode 7 consisting of AuGe/Ni are formed on the heavily doped layers 3 and 4 to be in ohmic contact with the heavily doped layers 3 and 4, respectively.

Here, the active layer 2 has a dopant concentration of about $2 \times 10^{18}$ cm$^{-3}$ and a thickness of about 0.01 $\mu$m. The heavily doped layers 3 and 4 have a dopant concentration of about $2 \times 10^{17}$ cm$^{-3}$ and a thickness of about 0.07 $\mu$m, respectively. The gate electrode 5 has a gate length of about 0.7 $\mu$m, a gate width of about 200 $\mu$m and a thickness of about 1 $\mu$m. The source electrode 6 and the drain electrode 7 have a thickness of about 0.1 $\mu$m, respectively. An interval between the gate electrode 5 and the source electrode 6 is about 0.5 $\mu$m. An interval between the gate electrode 5 and the drain electrode 7 is about 2 $\mu$m.

In this FET, the active layer 2 is formed in correspondence with a gate width $W_G$ determined by requirements on the circuit design. In consideration of the alignment margin of pattern formation with respect to the active layer 2, the gate electrode 5 is formed partially larger than the active layer 2 along a direction of the gate width $W_G$. Exceeding the alignment margin with respect to the active layer 2, the heavily doped layers 3 and 4 are formed to largely extend beyond the active layer 2 along the direction of the gate width $W_G$. In consideration of the alignment margin with respect to the heavily doped layers 3 and 4, the source and drain electrodes 6 and 7 are formed partially larger than the heavily doped layers 3 and 4 along the direction of the gate width $W_G$, respectively.

As described above, the contact width $W_C$ on the source and drain electrodes is set with respect to the gate width $W_G$ to satisfy

$$1[\mu m] + W_C < W_C < 5W_G.$$

Therefore, in this FET, the contact width $W_C$ on the source and drain electrodes is designed to be larger than the gate width $W_G$ at a predetermined ratio, as in the first embodiment.

According to the above structure, the function of this embodiment is almost the same as that of the first embodiment.

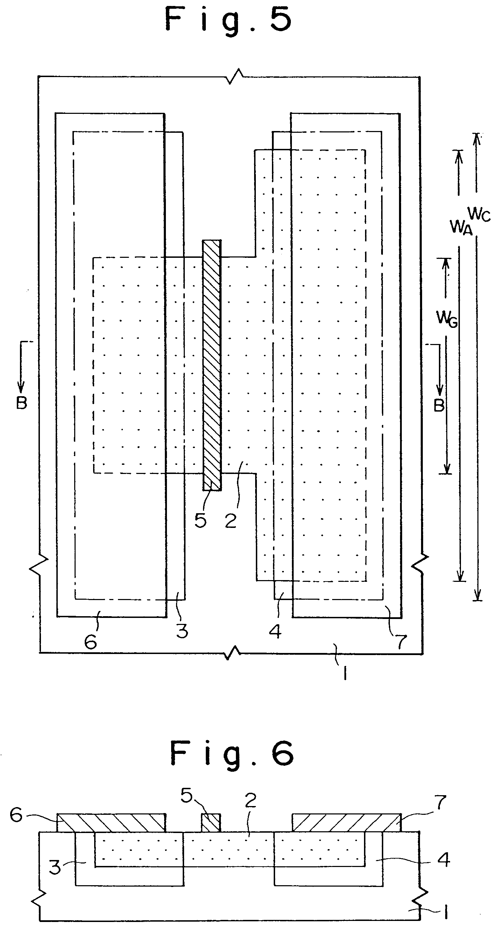

Fig. 5 is a plan view showing the structure of a field effect transistor according to the third embodiment of the present invention. Fig. 6 is a sectional view showing the structure taken along a line B - B in Fig. 5. In this embodiment, the present invention is applied to a GaAs-MESFET having a structure often used in a high output FET which particularly requires a high breakdown voltage.

A donor impurity such as Si ions is selectively ion-implanted in a predetermined surface region of a semiconductor substrate 1 consisting of GaAs to form an n-type active layer 2. The donor impurity such as Si ions is further selectively ion-implanted at the two end portions of the active layer 2 to form n-type heavily doped layers 3 and 4.

A gate electrode 5 consisting of Ti/Pt/Au is formed on the active layer 2 to be in Schottky contact with the active layer 2. A source electrode 5 and a drain electrode 7 consisting of AuGe/Ni are formed on the heavily doped layers 3 and 4 to be in ohmic contact with the heavily doped layers 3 and 4, respectively.

Here, the active layer 2 has a dopant concentration of about $2 \times 10^{18}$ cm$^{-3}$ and a thickness of about 0.01 $\mu$m. The heavily doped layers 3 and 4 have a dopant concentration of about $2 \times 10^{17}$ cm$^{-3}$ and a thickness of about 0.07 $\mu$m, respectively. The gate electrode 5 has a gate length of about 0.5 $\mu$m, a gate width of about 200 $\mu$m and a thickness of about 1 $\mu$m. The source electrode 6 and the drain electrode 7 have a thickness of about 0.1 $\mu$m, respectively. An interval between the gate electrode 5 and the source electrode 6 is about 0.5 $\mu$m. An interval between the gate electrode 5 and the drain electrode 7 is about 2 $\mu$m.

In this FET, the active layer 2 is formed in correspondence with the gate width $W_G$ determined by requirements on the circuit design. However, the active layer 2 is formed to overlap the gate-electrode-side edge portion of the drain electrode 7 in a size larger than the gate width $W_G$. In consideration of the alignment margin of pattern formation with respect to the active layer 2, the gate electrode 5 is formed partially larger than the active layer 2 along a direction of the gate width $W_G$ and arranged closer to the heavily doped layer 3 overlapping a source electrode 6 than the heavily doped layer 4 overlapping the drain electrode 7. Exceeding the alignment margin with respect to the active layer 2, the heavily doped layer 3 is formed to largely extend beyond the active layer 2 along the direction of the gate width $W_G$. In consideration of the alignment margin with respect to the active layer 2, the heavily doped layer 4 is formed partially larger than the active layer 2 along the direction of the gate width $W_G$ . In consideration of the alignment margin with respect to the heavily doped layers 3 and 4, the source and drain electrodes 6 and 7 are formed partially larger than the heavily doped layers 3 and 4 along the direction of the gate width $W_G$, respectively.

As described above, the contact width $W_C$ on the source and drain electrodes is set with respect to the gate width $W_G$ to satisfy

$$1[\mu m] + W_G < W_C < 5W_G.$$

A length $W_A$ of a portion where a gate-electrode-side portion of the drain electrode and the active layer overlap each other is set with respect to the length $W_G$ to satisfy

$$1[\mu m] + W_G < W_A < 5W_G.$$

Therefore, in this FET, the contact width $W_C$ on the source and drain electrodes and the length $W_A$ of a portion where a gate-electrode-side portion of the drain electrode and the active layer overlap each other are designed to be larger than the gate width $W_G$ at a predetermined ratio, as in the first embodiment.

According to the above structure, the function of this embodiment is almost the same as that of the first embodiment. In addition, in this FET, the active layer 2 is patterned to be partially largely extend along the direction of the gate width $W_G$ such that the length $W_A$ of a portion where a gate-electrode-side portion of the drain electrode 7 and the active layer 2 overlap each other becomes larger than the gate width $W_G$ determined by requirements on the circuit design at a predetermined ratio. With this structure, since a drain current flowing in the gate-electrode-side edge portion of the drain electrode 7 is distributed as compared to the first embodiment. For this reason, the contact resistance $R_C$ of the ohmic electrode is further reduced.

Furthermore, since the gate electrode 5 is arranged closer to the heavily doped layer 3 overlapping the source electrode 6 than the heavily doped layer 4 overlapping the drain electrode 7, the series resistance $R_D$ between the gate electrode 5 and the drain electrode 7 increases. Therefore, the drain breakdown voltage increases.

In this embodiment, the active layer 2 is formed by selectively doping the donor impurity in the semiconductor substrate 1. However, the active layer 2 can also be crystal-grown and formed into a mesa shape, as in the second embodiment, to obtain the same effect as described above.

In a conventional FET, to obtain a maximum transconductance gm, the heavily doped layer 3 overlapping the source electrode 6 is formed to extend to the limit of the alignment margin necessary for pattern formation. However, when the alignment margin is ensured to some extent, the active layer 2 is formed to also overlap the gate-electrode-side edge portion of the source electrode 6 in a size larger than the gate width $W_G$, thereby further reducing the contact resistance $R_C$ of the ohmic electrode.

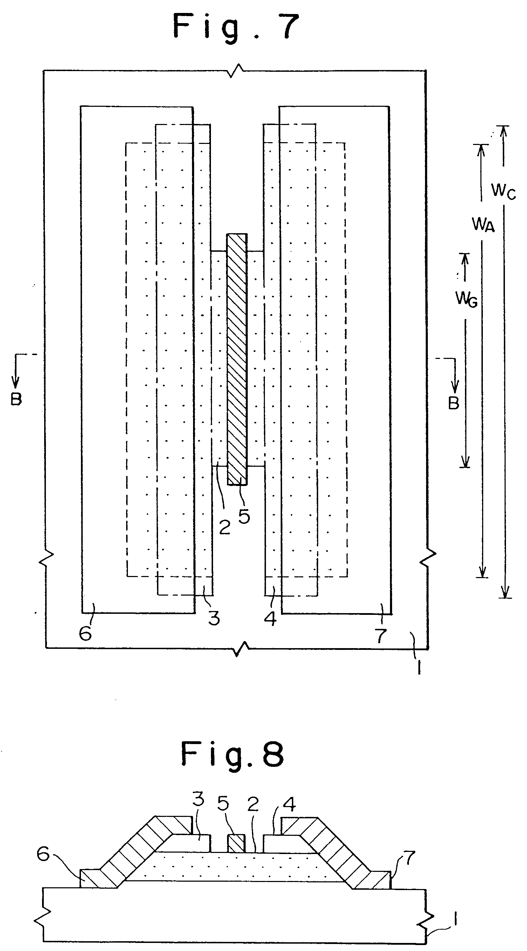

Fig. 7 is a plan view showing the structure of a field effect transistor according to the fourth embodiment of the present invention. Fig. 8 is a sectional view showing the structure taken along a line B - B in Fig. 7. Also in this embodiment, the present invention is applied to a GaAs-MESFET.

An n-type active layer 2 doped with a donor impurity such as Si ions and n-type heavily doped layers 3 and 4 doped with the donor impurity such as Si ions are sequentially crystal-grown on a semiconductor substrate 1 consisting of GaAs. The active layer 2 and the heavily doped layers 3 and 4 are etched into a mesa shape and devices are isolated from each other. The heavily doped layers 3 and 4 are isolated from each other by etching a groove to which the active layer 2 is exposed.

A gate electrode 5 consisting of Ti/Pt/Au is formed on the active layer 2 exposed in this recessed structure to be in Schottky contact with the active layer 2. A source electrode 6 and a drain electrode 7 consisting of AuGe/Ni are formed on the heavily doped layers 3 and 4 to be in ohmic contact with the heavily doped layers 3 and 4, respectively.

Here, the active layer 2 has a dopant concentration of about $2 \times 10^{18}$ cm$^{-3}$ and a thickness of about 0.01 $\mu m$. The heavily doped layers 3 and 4 have a dopant concentration of about $2 \times 10^{17}$ cm$^{-3}$ and a thickness of about 0.07 $\mu m$, respectively. The gate electrode 5 has a gate length of about 0.7 $\mu m$, a gate width of about 200 $\mu m$ and a thickness of about 1 $\mu m$. The source electrode 6 and the drain electrode 7 have a thickness of about 0.1 $\mu m$, respectively. An interval between the gate electrode 5 and the source electrode 6 is about 0.5 $\mu m$. An interval between the gate electrode 5 and the drain electrode 7 is about 1 $\mu m$.

In this FET, the active layer 2 is formed in correspondence with the gate width $W_G$ determined by requirements on the circuit design. However, the active layer 2 is formed to overlap the gate-electrode-side edge portions of the source and drain electrodes 6 and 7 in a size larger than the gate width $W_G$. In consideration of the alignment margin of pattern formation with respect to the active layer 2, the gate electrode 5 is formed partially larger than the active layer 2 along a direction of the gate width $W$ . In consideration of the alignment margin with respect to the active layer 2, the heavily doped layers 3 and 4 are formed partially larger than the active layer 2 along the direction of the gate width $W_G$, respectively. In consideration of the alignment margin with respect to the heavily doped layers 3 and 4, the source and drain electrodes 6 and 7 are formed partially larger than the heavily doped layers 3 and 4 along the direction of the gate width $W_G$, respectively.

As described above, the contact width $W_C$ on the source and drain electrodes is set with respect to the gate width $W_G$ to satisfy

$$1[\mu m] + W_G < W_C < 5W_G.$$

A length $W_A$ of a portion where gate-electrode-side portions of the source and drain electrodes and the active layer overlap each other is set with respect to the length $W_G$ to satisfy

$$1[\mu m] + W_G < W_A < 5W_G.$$

Therefore, in this FET, the contact width $W_C$ on the source and drain electrodes and the length $W_A$ of a portion where gate-electrode-side portions of the source and drain electrodes and the active layer overlap each other are designed to be larger than the gate width $W_G$ at a predetermined ratio, as in the first embodiment.

According to the above structure, the function of this embodiment is almost the same as that of the first embodiment. In addition, in this FET, the active layer 2 is patterned to be partially largely extend along the direction of the gate width $W_G$ such that the length $W_A$ of a portion where gate-electrode-side portions of the source and drain electrodes 6 and 7 and the active layer 2 overlap each other becomes larger than the gate width $W_G$ determined by requirements on the circuit design at a predetermined ratio. With this structure, since a drain current flowing in the gate-electrodes-side edge portion of the ohmic electrodes is distributed as compared to the first embodiment. For this reason, the contact resistance $R_C$ of the ohmic electrode is further reduced.

In this embodiment, the active layer 2 and the heavily doped layers 3 and 4 are crystal-grown on the semiconductor substrate 1 and formed into a mesa shape. However, as in the first embodiment, they can also be formed by selectively doping a donor impurity in the semiconductor substrate 1 to obtain the same effect as described above.

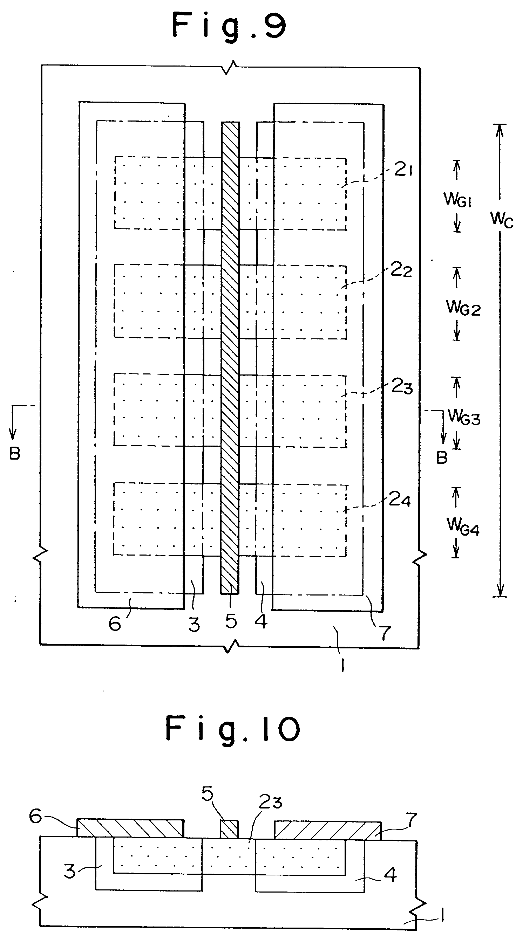

Fig. 9 is a plan view showing the structure of a field effect transistor according to the fifth embodiment of the present invention. Fig. 10 is a sectional view showing the structure taken along a line B - B in Fig. 9. Also in this embodiment, the present invention is applied to a GaAs-MESFET. It can be applied to the structures of all the above embodiments.

A donor impurity such as Si ions is selectively ion-implanted in plural predetermined surface regions of a semiconductor substrate 1 consisting of GaAs to form n-type active layers $2_1$ to $2_4$. The plurality of divided active layers $2_1$ to $2_4$ are arranged along a direction of the gate width $W_G$ at a predetermined interval. The donor impurity such as Si ions is further selectively ion-implanted at the two end portions of the plurality of active layers $2_1$ to $2_4$ to form n-type heavily doped layers 3 and 4.

A gate electrode 5 consisting of Ti/Pt/Au is formed on the active layers $2_1$ to $2_4$ to be in Schottky contact with the active layer 2. A source electrode 5 and a drain electrode 7 consisting of AuGe/Ni are formed on the heavily doped layers 3 and 4 to be in ohmic contact with the heavily doped layers 3 and 4, respectively.

Here, the active layer 2 has a dopant concentration of about $2 \times 10^{18}$ cm$^{-3}$ and a thickness of about 1 $\mu m$. The heavily doped layers 3 and 4 have a dopant concentration of about $2 \times 10^{17}$ cm$^{-3}$ and a thickness of about 0.07 $\mu m$, respectively. The gate electrode 5 has a gate length of about 0.5 $\mu m$, a gate width of about 200 $\mu m$ and a thickness of about 1 $\mu m$. The source electrode 6 and the drain electrode 7 have a thickness of about 0.1 $\mu m$, respectively. An interval between the gate electrode 5 and the source electrode 6 is about 20 $\mu m$. An interval between the active layers $2_1$ to $2_4$ is about 0.5 $\mu m$. An interval between the gate electrode 5 and the drain electrode 7 is about 2 $\mu m$.

In this FET, the active layers $2_1$ to $2_4$ is formed in correspondence with the gate width $W_G$ determined by requirements on the circuit design. However, the gate width $W_G$ determined by requirements on the circuit design accords with the sum ( $W_{G1} + W_{G2} + W_{G3} + W_{G4}$ )of gate width $W_{G1}$ to $W_{G4}$ corresponding to the active layers $2_3$ to $2_4$. In consideration of the alignment margin of pattern formation with respect to the active layers $2_3$ to $2_4$, the gate electrode 5 is formed partially larger than the active layers $2_1$ to $2_4$ along a direction of the gate width $W_G$. Exceeding the alignment margin with respect to the active layers $2_1$ to $2_4$, the heavily doped layers 3 to 4 are formed to largely extend beyond the active layers $2_1$ to $2_4$ along the direction of the gate width $W_G$, respectively. In consideration of the alignment margin with respect to the heavily doped layers 3 and 4, the source and drain electrodes 6 and 7 are formed partially larger than the heavily doped layers 3 and 4 along the direction of the gate width $W_G$, respectively.

As described above, the contact width $W_C$ on the source and drain electrodes is set with respect to the gate width $W_G$ to satisfy

$$1[\mu m] + W_G < W_C < 5W_G.$$

Therefore, in this FET, the contact width $W_C$ on the source and drain electrodes are designed to be larger than the gate width $W_G$ at a predetermined ratio, as in the first embodiment.

According to the above structure, the function of this embodiment is almost the same as that of the first embodiment. In addition, in this FET, the plurality of divided active layers $2_1$ to $2_4$ are arranged along a direction of the gate width $W_G$ at a predetermined interval. With this structure, since a drain current flowing in the gate-electrode-side edge portions of the ohmic electrodes uniformly flows along the direction of the gate width $W_G$ as compared to the first embodiment. For this reason, the contact resistance $R_C$ of the ohmic electrodes is further reduced.

In this embodiment, the active layers $2_N$ are formed by selectively doping the donor impurity in the semiconductor substrate 1. However, as in the second embodiment, the active layers $2_N$ can also be crystal-grown and formed into a mesa shape to obtain the same effect as described above. Here, N is an arbitrary natural number.

When the present invention is applied to an integrated circuit or the like, the sizes of the plurality of active layers $2_N$ or the shapes of the active layers $2_N$ overlapping the source or drain electrode 6 or 7 may be different because of the limitation on the layout design. Even in these cases, however, according to this embodiment, the same effect as described above can be obtained.

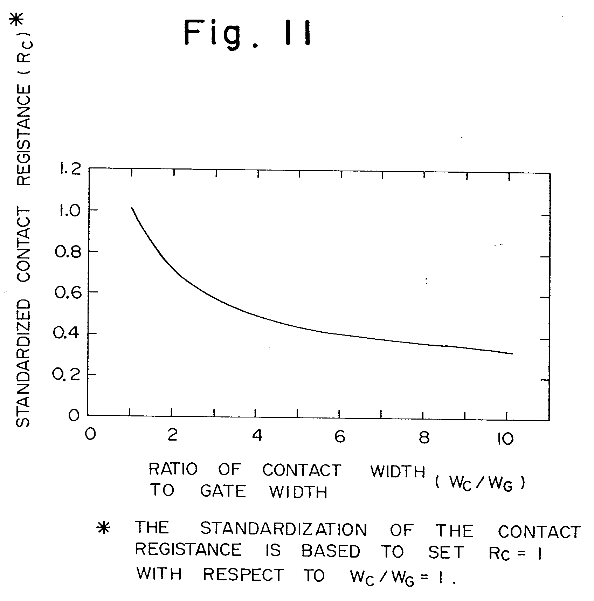

Fig. 11 is a graph showing the relationship between a ratio of the contact width to the gate width and the contact resistance in the field effect transistors according to the above embodiments of the present invention.

Generally, in the above embodiments, the contact resistance $R_C$ is represented with respect to the contact width $W_C$ as shown at a next formula.

$$R_C = ( r_C \cdot R_{SC} / W_C )^{1/2}$$

Here, $r_C$ is a resistivity [$\Omega \cdot cm$] on a contact portion between the ohmic electrode and the heavily doped layer, $R_{SC}$ is a sheet resistance [$\Omega$] on the heavily doped layer contacting with the ohmic electrode, and $W_C$ is a contact width [cm].

Usually, the resistivity $r_C$ and the sheet resistance $R_{SC}$ can be next values, respectively.

$$r_C = 0.8 \times 10^{-6} \sim 4 \times 10^{-6} \ \Omega \cdot cm,$$
$$R_{SC} = 100 - 200 \ \Omega$$

And the contact resistance $R_C$ is represented with respect to a ratio $W_C/W_G$ of the contact width $W_C$ to the gate width $W_G$ as shown a next formula if the gate width $W_G$ is assumed as a constant number.

$$R_C = C_0 \cdot (W_C/ W_G )^{-1/2}$$

Here, $C_0$ is a proportional constance number [$\Omega$].

The graph shown in Fig. 11 is obtained by plotting values of the contact resistance $R_C$ corresponding with the range $1 \leqq W_C/W_G \leqq 10$ based on this formula. The values of the contact resistance $R_C$ are standardized as $C_0 = 1$ to obtain $R_C = 1$ with respect to $W_C/W_G = 1$.

According to this graph, in case of $W_C/W_G \geqq 5$, the contact resistance $R_C$ is less than a half of that in case of $W_C/W_G = 1$ and shows a saturated tendency as increasing the value of $W_C/W_G$. In such cases, the gate width $W_G$ and the contact width $W_C$ can not be obtained as practical values because a size of a semiconductor tip forming the FET becomes a excessive value. For this reason, it is preferable that the value of $W_C/W_G$ is less than 5. However, it is more preferable that the value of $W_C/W_G$ is larger within the permissive range of the semiconductor tip size.

On the other hand, in case of $W_C/W_G \fallingdotseq 1$, the contact resistance $R_C$ shows the rapid reducing tendency as increasing the value of $W_C/W_G$. However, the contact resistance $R_C$ is only slightly reducing from that in case of $W_C/W_G = 1$ if a difference ( $W_C$ - $W_G$ ) between the contact width $W_C$ and the gate width $W_G$ is less than the usual alignment margin on exposure, i.e., the range of 0.1 to 1 $\mu m$. For this reason, it is preferable that the contact width $W_C$ is larger than the gate width $W_G$ by 1 $\mu m$.

Therefore, in the above embodiments, it is preferable that the contact width $W_C$ satisfies

$$1[\mu m] + W_G < W_C < 5W_G$$

with respect to the gate width $W_G$. A consideration of the above formula representing the contact width $W_C$ is described in detail in "Ralph E. Williams, Gallium Arsenide Processing Techniques, chap.11, Artech House Inc., 1984".

The present invention is not limited to the above embodiments, and various changes and modifications can be made.

For example, in the above embodiments, the contact width $W_C$ of each of the two ohmic electrodes is larger than the gate width $W_G$. However, when the present invention is applied to an integrated circuit or the like, because of the limitation on the layout design, the contact width $W_C$ of only one of the source and drain electrodes can be formed larger than the gate width $W_G$ to obtain the same effect as described above.

As has been described above in detail, in the field effect transistor of the present invention, the length of a portion where the gate-electrode-side edge portion of at least one of the source and drain electrodes and the heavily doped layer overlap each other is larger than that of a portion where the source- or drain-electrode-side edge portion of the gate electrode and the active layer overlap each other, which is determined by requirements on the circuit design, at a predetermined ratio beyond the minimum necessary size of the alignment margin for pattern formation of the active and heavily doped layers. For this reason, a drain current flowing in the gate-electrode-side edge portion of the source or drain electrode is uniformly distributed as compared to the prior art, thereby reducing the contact resistance of the source or drain electrode.

As a result, with a structure in which a distance between the gate electrode and the source or drain electrode is held at a predetermined value to ensure a high breakdown voltage, the source-drain resistance in an ON state can be reduced to a desired value. Therefore, by applying the field effect transistor of the present invention, power consumption of a power amplification circuit can be reduced, i.e., the power efficiency can be improved, and an insertion loss of a high-frequency switching circuit can be reduced.

As a result, the present invention is realized by changing the etching mask pattern to change the layout design of the heavily doped layers and the corresponding ohmic electrodes, or the active layer and the corresponding gate electrode in the same structure perpendicular to the semiconductor substrate surface as that of the prior art. For this reason, according to the present invention, there is provided a high-performance field effect transistor which operates at the high-frequency microwave band without changing the conventional manufacturing process.

From the invention thus described, it will be obvious that the invention may be varied in many ways. Such variations are not to be regarded as a departure from the spirit and scope of the invention, and all such modifications as would be obvious to one skilled in the art are intended to be included within the scope of the following claims.

The basic Japanese Application No. 192328/1993 filed on August 3, 1993 is hereby incorporated by reference.

**Claims**

1. A field effect transistor comprising:
   a semiconductor substrate;
   an active layer formed by doping an impurity in a surface region of said semiconductor substrate;
   two heavily doped layers formed respectively by doping said impurity at two end portions of said active layer;
   a gate electrode formed on said active layer to be in Schottky contact with said active layer; and
   source and drain electrodes formed respectively on said two heavily doped layers to be in ohmic contact with said two heavily doped layers,
   wherein a length $W_C$ of a portion where a gate-electrode-side portion of at least one of said source and drain electrodes and said heavily doped layer overlap each other is larger than a length $W_G$ of a portion where at least one of source- and drain-electrode-side edge portions of said gate electrode and said active layer overlap each other beyond the necessary minimum size of the alignment margin for pattern formation of said active layer and said heavily doped layers.

2. A transistor according to claim 1, wherein said length $W_C$ is within the range where the concentration of a current flowing in a gate-electrode-side edge portion of at least one of said source and said drain electrodes is sufficiently relaxed.

3. A transistor according to claim 1, wherein a length $W_A$ of a portion where a gate-electrode-side portion of at least one of said source and drain electrodes and said activity layer overlap each other is larger than said length $W_G$ beyond the necessary minimum size of the alignment margin for pattern formation of said active layer and said heavily doped layers.

4. A field effect transistor comprising:
   a semiconductor substrate;
   an active layer formed by doping an impurity in a surface region of said semiconductor substrate;
   two heavily doped layers formed respectively by doping said impurity at two end portions of said active layer;
   a gate electrode formed on said active layer to be in Schottky contact with said active layer;
   a source electrode formed on one of said two heavily doped layers to be in ohmic contact with said one heavily doped layer; and
   a drain electrode formed on the other of said two heavily doped layers to be in ohmic contact with said the other heavily doped layer,
   wherein a length $W_C$ of a portion where a gate-electrode-side portion of at least one of said source and drain electrodes and said heavily doped layer overlap each other is set with respect to a length $W_G$ of a portion where at least one of source- and drain-electrode-side edge portions of said gate electrode and said active layer overlap each other to satisfy

$$1[\mu m] + W_G < W_C < 5W_G.$$

5. A transistor according to claim 1 or 4, wherein a length $W_C$ of a portion where a gate-electrode-side portion of at least one of said source and drain electrodes and said heavily doped layer overlap each other is set with respect to said length $W_G$ to satisfy

$$1[\mu m] + W_G < W_A < 5W_G.$$

6. A transistor according to claim 1 or 4, wherein said active layer is divided into a plurality of active layers and arranged along a direction of a portion where at least one of source- and drain-electrode-side edge portions of said gate electrode and said active layer overlap each other at a predetermined interval.

7. A transistor according to claim 1 or 4, wherein said gate electrode is arranged closer to said heavily doped layer overlapping said source electrode than said heavily doped layer overlapping said drain electrode.

8. A transistor according to claim 1 or 4, wherein said active layer is formed by selectively doping said impurity in said semiconductor substrate, and said heavily doped layers are formed respectively by selectively doping said impurity at said two end portions of said active layer.

9. A transistor according to claim 1 or 4, wherein said heavily doped layers are formed respectively by selectively doping said impurity in said semiconductor substrate, said active layer is doped with said impurity, crystal-grown on said heavily doped layers, and formed into a mesa shape, and devices are isolated from each other.

10. A transistor according to claim 1 or 4, wherein said active layer and said heavily doped layers are doped with said impurity, sequentially crystal-grown on said semiconductor substrate, and formed into a mesa shape, and devices are isolated from each other.

# Fig. 1

# Fig. 2

# Fig. 3

$W_C$

$W_G$

B

B

2  5

3

4

6

7

I

# Fig. 4

5  2

6

7

3

4

I

# Fig. 5

5  2

B

$W_C$
$W_A$
$W_G$
B

6  3  4  7

1

# Fig. 6

5  2

6  7

3  4

1

# Fig.7

# Fig.8

# Fig.9

# Fig.10

# Fig. 11

Graph axes:
- Vertical axis: STANDARDIZED CONTACT RESISTANCE ($R_C$) *
- Horizontal axis: RATIO OF CONTACT WIDTH TO GATE WIDTH ($W_C / W_G$)

* THE STANDARDIZATION OF THE CONTACT RESISTANCE IS BASED TO SET $R_C = 1$ WITH RESPECT TO $W_C / W_G = 1$.

| | European Patent Office | EUROPEAN SEARCH REPORT | Application Number EP 94 11 2155 |

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| Y | FR-A-2 561 822 (THOMSON-CSF) <br> * the whole document * <br> --- | 1-6,8 | H01L29/812 <br> H01L29/08 <br> H01L29/10 |
| Y | WO-A-88 03328 (HUGHES AIRCRAFT COMPANY) <br> * the whole document * <br> --- | 1-6,8 | |
| A | PATENT ABSTRACTS OF JAPAN <br> vol. 12, no. 447 (E-685) 21 November 1988 <br> & JP-A-63 175 481 (HITACHI LTD) 19 July 1988 <br> * abstract * <br> --- | 1,2 | |
| A | PATENT ABSTRACTS OF JAPAN <br> vol. 9, no. 328 (E-369) 24 December 1985 <br> & JP-A-60 160 176 (FUJITSU KK) 21 August 1985 <br> * abstract * <br> --- | 1-6 | |
| A | PATENT ABSTRACTS OF JAPAN <br> vol. 17, no. 484 (E-1426) 2 September 1993 <br> & JP-A-05 121 457 (NEC CORP) 18 May 1993 <br> * abstract * <br> --- | 1,2,6 | TECHNICAL FIELDS SEARCHED (Int.Cl.6) <br><br> H01L |
| A | PATENT ABSTRACTS OF JAPAN <br> vol. 13, no. 220 (E-762) 23 May 1989 <br> & JP-A-01 032 680 (HITACHI LTD) 2 February 1989 <br> * abstract * <br> --- | 7,10 | |
| A | PATENT ABSTRACTS OF JAPAN <br> vol. 6, no. 205 (E-136) 16 October 1982 <br> & JP-A-57 112 079 (FUJITSU KK) 12 July 1982 <br> * abstract * <br> ----- | 9 | |

The present search report has been drawn up for all claims

| Place of search | Date of completion of the search | Examiner |
|---|---|---|
| THE HAGUE | 12 December 1994 | Mimoun, B |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)